# EUROPEAN PATENT APPLICATION

(11) **EP 2 811 417 A2**
(43) Date of publication of application: **10.12.2014**
(21) Application number: 14170924.6
(22) Date of filing: 03.06.2014
(51) Int. Cl.: G06F 17/30

(54) **Systems and methods for synchronizing geographic information system (GIS) network models**

(30) Priority: 03.06.2013 US 201313908966
(71) Applicant: General Electric Company, Schenectady, New York 12345 (US)
(72) Inventor: Stanislawski, Michael, Cambridge, Cambridgeshire CB4 1WR (GB); Carballar, Enrique Cano, Cambridge, Cambridgeshire CB4 1WR (GB); Hill, Lee, Cambridge, Cambridgeshire CB4 1WR (GB); Simons, Glenda Paulette, Cambridge, Cambridgeshire CB4 1WR (GB)
(74) Representative: Illingworth-Law, William Illingworth

(57) **Abstract**

A system 12 includes a processor configured to identify a modification to a utility grid, and to derive a first model 30 of the utility grid and a second model 32 of the utility grid. The second model 32 of the utility grid includes a modification of the first model 30 of the utility grid. The processor is configured to compare the first model 30 of the utility grid to the second model 32 of the utility grid, and to derive a difference between the first model 30 of the utility grid and the second model 32 of the utility grid based at least in part on the comparison 40.

## Description

The invention relates generally to geographic information systems, and more specifically to methods and systems for synchronizing models of the geographic information systems.

A geographic information system (GIS), sometimes referred to as a geographical information system or a geospatial information system, is a system for capturing, storing, analyzing and managing data and associated attributes which are spatially referenced to, for example, the planet Earth. GIS systems may integrate hardware, software, and data for capturing, managing, analyzing, and displaying all forms of geographically referenced information. For example, GIS systems may provide information about the location of items, such as buildings, streets, sewers, lamp posts, etc., as well as information about the items themselves. GIS systems may be also subject to frequent updating to reflect changes in the geographically referenced information, while other external systems depending on the GIS systems may not receive frequent updates. It may be useful to provide methods to synchronize the geographically referenced information of the GIS systems with other external systems.

Certain embodiments commensurate in scope with the existing claimed invention are summarized below. These embodiments are not intended to limit the scope of the claimed invention, but rather these embodiments are intended only to provide a brief summary of possible forms of the invention. Indeed, the invention may encompass a variety of forms that may be similar to or different from the embodiments set forth below.

In a first embodiment, a system includes a processor configured to identify a modification to a utility grid, and to derive a first model of the utility grid and a second model of the utility grid. The second model of the utility grid includes a modification of the first model of the utility grid. The processor is configured to compare the first model of the utility grid to the second model of the utility grid, and to derive a difference between the first model of the utility grid and the second model of the utility grid based at least in part on the comparison.

In a second embodiment, a non-transitory computer-readable medium having code stored thereon is provided, and the code includes instructions to identify one or more modifications to a geographic information system (GIS) model, derive a first model of the GIS model and a second model of the GIS model. The second model includes a modification of the first model. The code includes instructions to compare the first model to the second model, and to derive a difference between the first model and the second model based at least in part on the comparison.

In a third embodiment, a Geographic Information System (GIS) includes a processor configured to generate a representation of an electric power grid in a first state, receive an input as an indication to change the representation of the electric power grid to a second state, and derive a first model of the electric power grid in the first state and a second model of the electric power grid in the second state. The second model of the electric power grid includes at least one difference from the first model of the electric power grid. The processor is configured to compare the first model of the electric power grid to the second model of the electric power grid to quantify the at least one difference, and to derive a Common Information Model (CIM) representation of the at least one difference between the first model of the utility grid and the second model of the utility grid based at least in part on the comparison.

These and other features, aspects, and advantages of the present invention will become better understood when the following detailed description is read with reference to the accompanying drawings in which like characters represent like parts throughout the drawings, wherein:
FIG. 1 is a block diagram of an embodiment of a GIS system;
FIG. 2 is an embodiment of a spatial server including GIS system network models, in accordance with present embodiments;
FIGS. 3-8 are example embodiments of the network models of FIG. 2, in accordance with present embodiments; and
FIG. 9 is a flowchart illustrating an embodiment of a process suitable for synchronizing network models between GIS system of FIG. 1 and external systems, in accordance with present embodiments.

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements.

The techniques described herein enable the communicative coupling and synchronization between GIS systems to a variety of external systems. In certain embodiments, open standard models are used to share information between the communicatively coupled systems. By using open standards, any system that supports the standards may participate. However, changes to models may result in the entirety of the changed model being transmitted to interested systems. The techniques described herein may derive model changes and transmit only a subset of the changed model, rather than the entirety of the changed model. Changes may be derived based on localized searching of a graph (e.g., a representation of a utility network model), rather than be searching the entire graph for differences. By deriving only the changes (e.g., deriving a Common Information Model (CIM) model of the changes), the techniques described herein may improve information synchronization between a variety of systems and may reduce transmission times and cost by transmitting the derived differences only.

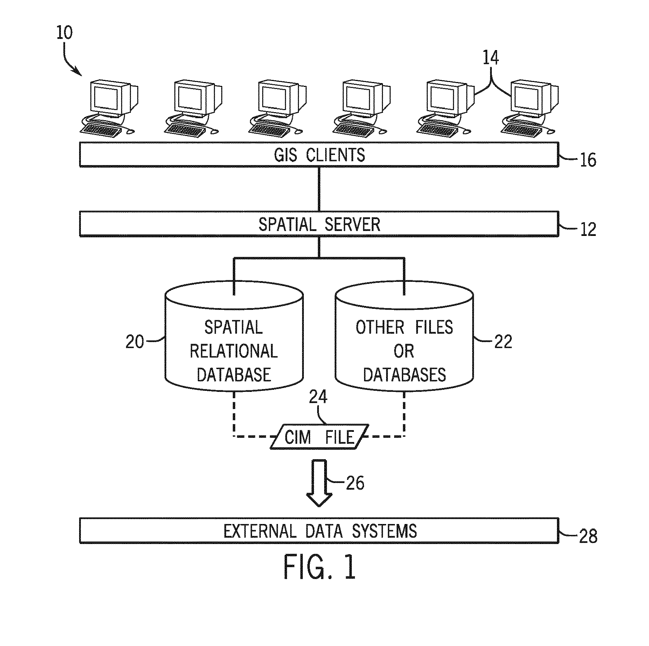

With the foregoing in mind, it may be useful to describe an embodiment of a Geographic Information System (GIS) system such as an example GIS system 10 illustrated in FIG. 1. The GIS system 10 may include a spatial server 12, and a number of client computers 14 communicatively coupled to the spatial server 12. In one embodiment, the client computers 14 may execute a web browser and/or a client software application, such that spatial server 12 is accessible to client computers 14 over a network, such as the Internet and/or an intranet. Client computers 14 may be interconnected to the Internet through many interfaces including a network, such as a local area network (LAN), a wide area network (WAN), dial-in-connections, cable modems, wireless modems, and/or special high-speed Integrated Services Digital Network (ISDN) lines. As described above, client computers 14 may be any device capable of interconnecting to the Internet, including, for example, a personal computer, portable computer, a tablet, a server, a router, a network computer, a vendor or manufacture's computing device, smart grid components, a peer device, a smart phone, etc., and may allow a GIS client 16, such as a human user or a software entity, to use the GIS system 10. As further illustrated in FIG. 1, the plurality of GIS clients 16 may connect to the spatial server 12.

The spatial server 12 may include memory capable of containing information on a variety of matters, such as information relating to one or more areas of interest of the GIS client 16, executable computer instructions, and the like, as well as a processor suitable for executing the computer instructions. Information from the spatial server 12 may be accessed by potential clients or users (e.g., GIS clients16) at one of the client computers 14 by logging onto the spatial server 12. In an additional or an alternative embodiment, memory may be stored remotely from the spatial server 12, and may be non-centralized. The spatial server 12 may functionally interface with one or more databases to store geospatial information and/ provide for a variety of functions, such as but not limited to publishing maps, sharing maps, providing for web services, providing for spatial analysis (e.g., vector, raster, network, and/or 3D analysis), providing for geographic display of conflicts and conflict resolution, delivering development tools and tool support, transforming between coordinate systems, managing versioned data stores, and so on. As described in more detail below, geospatial information may include, for example, a model related to the areas of interest, equipment information (e.g., location of power producing equipment and conduits, location of utility equipments and conduits, such as gas equipment, sewage equipment, location of computing equipment and conduits) weather conditions related to the areas of interest, and/or terrain data related to the areas of interest.

The spatial server 12 may be coupled to a spatial relational database 20, as well as other files or databases 22. The spatial relational database 20 may be an integrated set of functions and procedures that enables spatial data to be stored, accessed, and/or analyzed more quickly and efficiently in a database, such as the spatial server 12. The spatial relational database 20 may provide a structured query language (SQL) or similar schema and functions that facilitate the storage, retrieval, update, and query of collections of spatial features in a relational database. The database 20 may include the following components: a schema that prescribes the storage, syntax, and semantics of supported geometric data types; a spatial indexing mechanism; a set of operators and functions for performing area-of-interest queries, spatial join queries, and other spatial analysis operations; and administrative utilities. As will be further appreciated, the database 20 and other files or databases 22 may include data relating to modifications (e.g., due to physical and/or virtual retrofitting) to GIS networks and/or other management networks.

In certain embodiments, the spatial server 12 may be used to generate one or more Common Information Model (CIM) files 24 based on, for example, data included in the spatial relational database 20, the other files or databases 22, and/or data received from one or more external data services. In certain embodiments, the CIM file 24 may include any open systems management standard that may be used to model and export a network model (e.g., electric power network model, gas line network model, water systems network model, and so forth) over a communications network 26 to, for example, one or more external data systems 28.

The external data systems 28 may include various data and/or data management systems such as, for example, an outage management system (OMS) (e.g., electric power outage management), a distribution management system (DMS) (e.g., suitable for routing electric power, water, and/or gas through corresponding networks or grids), a Meter Data Management (MDM) system (e.g., useful in management of large quantities of utility data), an Engineering Analysis (EA) system, a customer information system (CIS), a work management system (WMS), a supervisory control and data acquisition system (SCADA), an enterprise resource planning (ERP) system, a customer relationship management (CRM) system and/or other external data and/or data management systems. As will be discussed in greater detail below, the CIM file 24 may, in some embodiments, include the only changes (e.g., additions, deletions, modifications, and so forth) made to the utility networks of the GIS system 10. Indeed, by providing for CIM files 24 or electronic transfer of CIM data and/or CIM XML files, the spatial server 12 may share GIS data to a wide variety of external systems 28. However, changes in CIM model, including simple changes such as the addition of a conduit, or complex changes such as the addition of a subnetwork, would then be communicated to the external systems 28 by transmitting the entire model containing the changes. The techniques described herein may accurately derive only the portions of the model that have been changed, and then transmit the changed portion. Further, the changed portion may be transmitted as a standard model (e.g., a Resource Description Framework (RDF) difference model, or other similar difference model) using techniques further described below, rather than as a proprietary differential model. Accordingly, the spatial server 12 may more efficiently synchronize with the external systems 28 and reduce transmission times and cost.

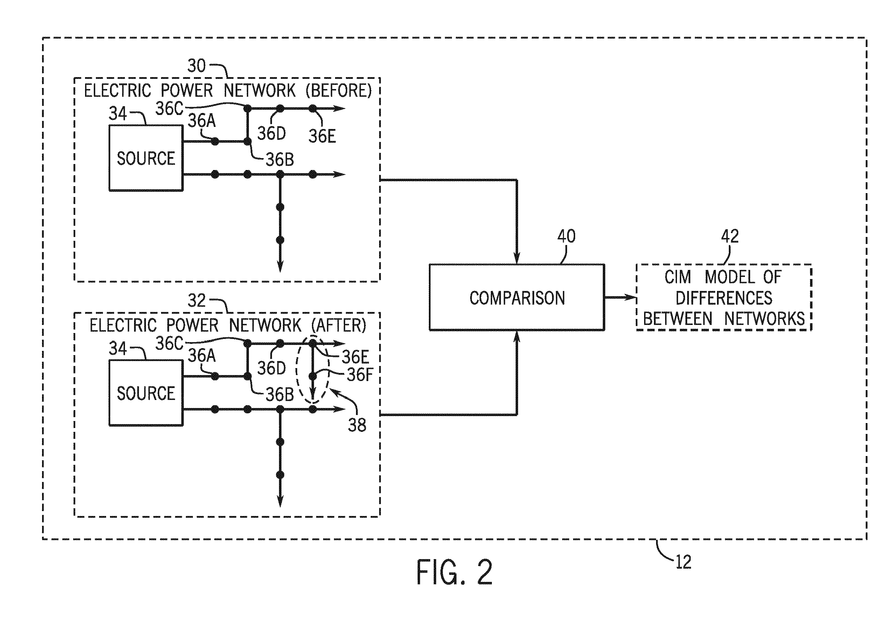

For example, FIG. 2 illustrates an example block diagram of the spatial server 12, which may be useful in modeling utility networks and generating and exporting a CIM file 24 based on changes made to, for example, a pre-existing utility network (e.g., electrical network). As it may be worth noting, although the present embodiments may be discussed primarily with respect to an electric power network, it should be appreciated the present techniques may be applicable to any of variety of utility networks, utility management systems, and any underlying system modeled via CIM and/or similar standard models. Accordingly, as depicted in FIG. 2, a model 30 of an electric power network in a pre-existing state (e.g., state before undergoing one or more modifications) may be generated (e.g., generated by the spatial server 12 as discussed above with respect to FIG. 1) and stored in memory and/or in the databases 20, 22. The electric power network model 30 may include, for example, one of many power distribution feeders that form a power distribution grid. Accordingly, as shown, the power network model 30 may include a model of a power source 34 (e.g., distribution substation or other transformer) and a model of a number of nodes 36A-36E. The nodes 36A-36E may represent poles (e.g., including smaller transformers) and the lines connecting the nodes 36A-36E may represent conductors (e.g., overhead and/or underground power lines) of the distribution grid. Specifically, the nodes 36A-36E may represent points on the distribution feeder where distribution voltages may be transformed or regulated before being distributed to electric power consumers along the distribution feeder or along laterals extending from the distribution feeder.

Similarly, as further depicted in FIG. 2, a model 32 of an electric power network in a modified state (e.g., model 30 after undergoing one or more modifications) may be generated by the spatial server 12. In certain examples, the electric power network model 32 may include substantially the same components and/or configurations as the power network model 30. However, in other examples, as depicted, the power network model 32 may include one or more modifications 38 not previously included within, for example, the power network model 30. Further, although illustrated as an addition of a component, it should be appreciated that the modification 38 may, in some embodiments, include an addition, a deletion, an update, or any combination thereof, of one or more components of the network models 30 and 32. Thus, the spatial server 12 may generate (and store) respective CIM network models 30 and 32 based on the power network in each of a pre-existing state and a modified state. The spatial server 12 may then compare the network models 30 and 32 via a comparison block 40 (e.g., a comparator or similar software and/or hardware system).

In certain embodiments, the spatial server 12 may compare the network models 30 and 32 to derive a CIM model 42 of only the differences (e.g., additions, updates or deletions of certain components or other modifications) existing between the network models 30 and 32. Upon deriving the differences between the network models 30 and 32, the spatial server 12 may store only the modifications to, for example, the model 32 in the generated CIM file 24 (e.g., generated based on the network models 30 and 32) for exporting to the external data systems 28 (e.g., DMS, OMS, MDM systems). In another embodiment, the CIM model 42, and by extension the CIM file 24, may include only a subset of the differences, such as the subset applicable to a CRM system related to customer changes, a SCADA system related to control changes, and so on. It is to be understood that the CIM model 42 and the CIM file 24 may also include all of the model 30 and the computed differences between model 30 and model 32, or both models 30 and 32 and the computed differences. In this way, the spatial server 12 may not only expedite synchronization of the power network models 30 and 32 with the external data systems 28, but also improve efficiency in the transmission and importing (e.g., loading) of the CIM file 24 by the external data systems 28. That is, the CIM file 24 may, in some embodiments, include only the portion(s) (e.g., a truncated network model) of the power network model 32, for example, that is different from the power network model 30. The file 24 may include an extensible markup language (XML) file compliant, for example with class-based uniform modelling language (UML) CIM models, including CIM schemas provided by the Distributed Management Task Force (DMTF). The CIM models may include xmlCIM encodings. The xmlCIM encoding may include a specification that defines XML elements, written in Document Type Definition (DTD), which can be used to represent CIM classes and instances. CIM models may further include a CIM Operations over HTTP specification which defines a mapping of CIM operations onto HTTP that allows implementations of CIM to interoperate in an open, standardized manner and completes the technologies that support the Web Based Enterprise Management (WBEM) initiative.

In certain embodiments, the spatial server 12 may also include within the generated CIM file 24 a number of sections (e.g., a forward-differences section, a reverse-differences section, and so forth), which may include partial and/or detailed information (e.g., data and/or metadata) relating to the network models 30 and 32. A forward-differences section may include information relating to the modifications (e.g., the one or more modifications 38) that were added and/or inserted into the pre-existing CIM network model 30. Indeed, the information included within forward-differences section of the generated CIM file 24 may allow a recipient resource (e.g., operator of the external data systems 28) to determine the CIM network model 30 (e.g., including connections and other parameters) based on knowledge of the modifications (e.g., forward-differences). On the other hand, a reverse-differences section may include information relating to the pre-existing CIM network model 30 (e.g., without the one or more modifications 38). The reverse-differences section may allow a recipient resource (e.g., operator of the external data systems 28) to determine modifications that may include deletions of certain components of the CIM network model 30. Collectively, in addition to additions, updates, and deletions, the forward-differences section and the reverse-differences section may include information relating to modifications including updates to components of the CIM network model 30.

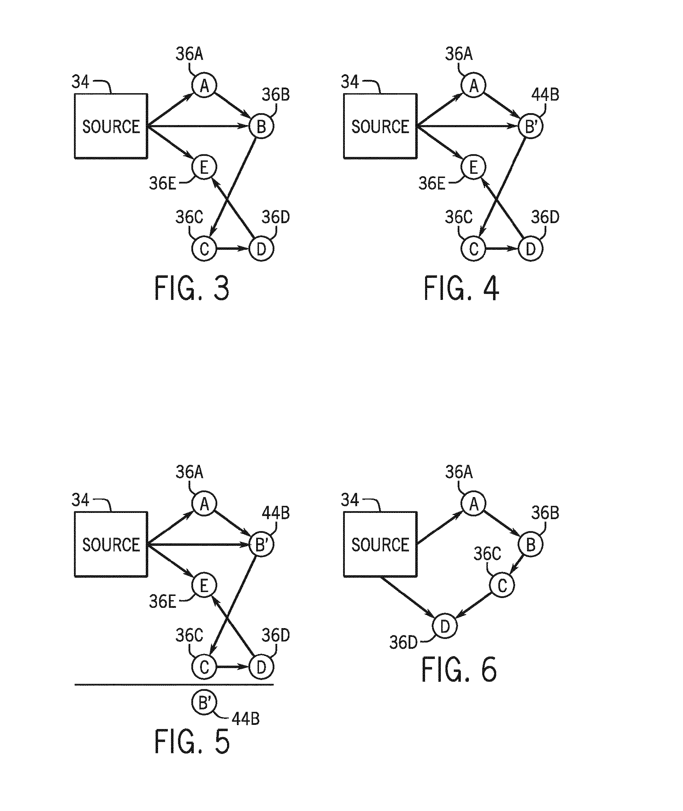

To further illustrate the aforementioned description, FIGS. 3-8 depict various examples of the presently disclosed techniques. It should be appreciated that the illustrations of FIGS. 3-8 are included merely for the purpose of example. That is, although power network models of FIGS. 3-8 may be limited to, for example, modifications to single network nodes 36 and/or connecting network nodes 36, it should be appreciated that in an actual implementation, any of a number of modifications such as large-scale additions or deletions of components (e.g., adding or removing substations, feeders, transformers, power conductors, and so forth) and small-scale modifications (e.g., adding, removing, or changing of switches, relays, or other protective devices) may be made to the power network GIS models 30 and 32.

Considering the foregoing, FIG. 3 depicts a power network model including the source 34 and network nodes 36A-36E similar to those as discussed above with respect to the power network models 30 and 32 of FIG. 2. In a similar manner, FIG. 4 illustrates the power network model of FIG. 3 with the exception that the network node 44B has been modified. In such a case, the spatial server 12 may generate before and after (e.g., without modification and with modification) CIM models of the power network models of FIGS. 3 and 4. As previously noted, the spatial server 12 may then derive and/or determine the differences between the before and after CIM models. Specifically, as illustrated in FIG. 5, the spatial server 12 may determine that only the network node 44B has been modified, and consequently only store the network node 44B to CIM file 24, for example, before exporting the CIM file 24 to the external data systems 28 (e.g., DMS, OMS, MDM, and so forth). The difference may be exported as compliant with a number of CIM standards, including CIM UML-compliant standards, and/or XML CIM representations including Document Number DSP0201 version 2.3.1 or newer available from DMTF, Inc. of Portland, Or.

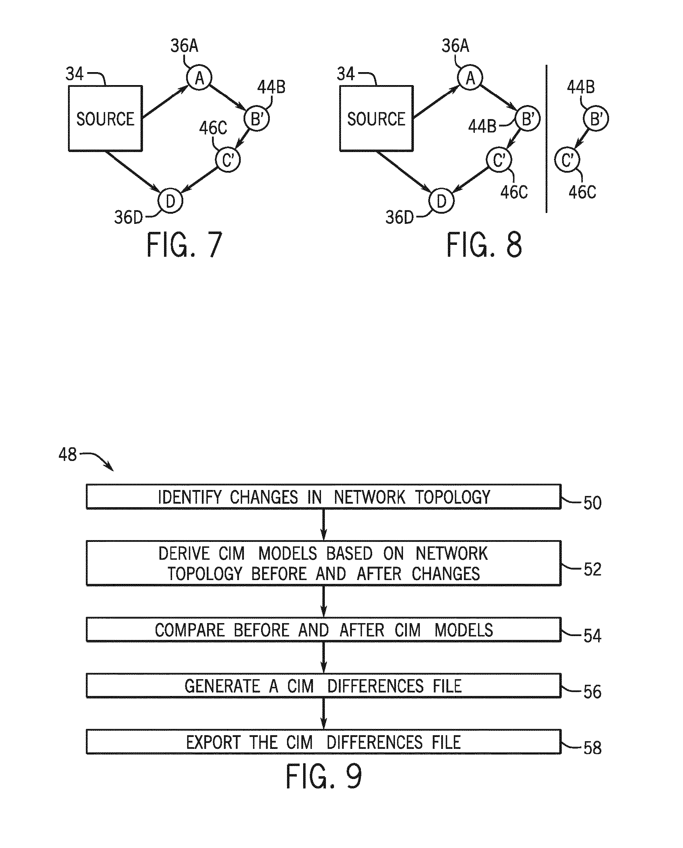

Similarly, FIGS. 6-8 illustrate examples of before and after (e.g., without modification and with modification) CIM models of the power network models (e.g., power network models 30 and 32 of FIG. 2). Specifically, FIG. 7 illustrates the power network model of FIG. 6 with the exception that the network node 44B, network node 46C, and the line (e.g., power line) connecting the network nodes 44B and 46C have each been modified. The spatial server 12 may generate before and after CIM models of the power network models of FIGS. 6 and 7. In a similar aforementioned manner, the spatial server 12 may then derive and/or determine the differences between the before and after CIM models of FIGS. 6 and 7. Indeed, as illustrated in FIG. 8, the spatial server 12 may then determine that only the network node 44B, the network node 46C, and the line (e.g., power line) connecting the network nodes 44B and 46C have been modified. Thus, the spatial server 12 may only store the network the network node 44B, the network node 46C, and the connecting line to CIM file 24, for example, before exporting the CIM file 24 to the external data systems 28 (e.g., DMS, OMS, MDM, and so forth).

A number of techniques may be used to determine the differences illustrated in FIGS. 3 to 8. In one embodiment, the spatial server 12 may keep a running log of changes, for example in memory or in the databases 20, 22, and use the running log as the differences. However, the running log may include extraneous information, such as a node that was inserted and then deleted, and thus is not in a previous or present model. Accordingly, the running log may be applied to the new model 32, for example, to determine changes that would desirably be communicated versus changes that would not be as useful to communicate. In one embodiment, node objects in the running log may be navigated, for example through breadth-first and/or depth first searches to determine other objects (e.g., links and/or nodes) that may have also changed. Likewise, changed links may be navigated to find local nodes and other links that also may have changed. By employing localized searches, rather by searching the entire models, differences may be derived more quickly and with less computing resources.

Turning now to FIG. 9, a flow diagram is presented, illustrating an embodiment of a process 48 useful in synchronizing network models (e.g., power network models) between a GIS and an external data system (e.g., DMS) by using, for example, the spatial server 12 included in the GIS system 10 depicted in FIG. 1. The process 48 may include code or instructions stored in a non-transitory machine-readable medium (e.g., a memory) and executed, for example, by one or more processors included in the spatial server 12. The process 48 may begin with the spatial server 12 identifying (block 50) changes or other modifications to a utility network topology. For example, as previously discussed, the spatial server 12 may identify one or more modifications 38 not previously included within, for example, a GIS representation of the network. The process 48 may continue with the spatial server 12 deriving (block 52) CIM models based on the utility network topology before and after such modifications. Specifically, a CIM network model (e.g., model 30 of FIG. 2) of a utility network in a pre-existing state (e.g., state before undergoing one or more modifications) may be generated and a CIM network model (e.g., model 32 of FIG. 2) in a modified state (e.g., after undergoing one or more modifications) may be generated by the spatial server 12.

The process 48 may then continue with the spatial server 12 comparing (block 54) the CIM network model of the pre-existing state (e.g., before modifications) to the CIM network model of the modified state (e.g., after modifications). For example, as noted above with respect to FIG. 2, the spatial server 12 may compare the before and after CIM models (e.g., network models 30 and 32) to determine only the differences (e.g., additions, updates, or deletions of certain components or other modifications) existing between the two CIM models. The process 48 may then continue with the spatial server 12 generating (block 56) a CIM file (e.g., CIM file 24) including the differences between the pre-existing state CIM network model (e.g., model 30) and the modified state CIM network model (e.g., model 32). Indeed, as previously noted, upon determining the differences between the CIM models, the spatial server 12 may generate the CIM model 42 and CIM file 24 (e.g., generated based on the network models 30 and 32) that includes the modifications and/or other information relating the modifications.

In some embodiments, the CIM model 42, and by extension the CIM file 24, may not include in the entire CIM network models 30 and 32, but instead only the portion(s) corresponding to the differences between the CIM network models 30 and 32. In other embodiments, CIM file 24 may include a forward-differences section (e.g., section of data relating to components added and/or inserted) and a reverse-differences section (e.g., section of data relating to components deleted) in addition to the differences between the CIM network models 30 and 32. In either embodiment, the spatial server 12 may expedite the synchronization of the power network models 30 and 32 with external data systems 28 by generating a CIM file 24 that may include only a truncated model (e.g., a CIM model 42 of only the differences) of the pre-existing network model, and thus improve efficiency in the transmission and later importing (e.g., loading) of the CIM file 24. The process 48 may then conclude with the spatial server 12 exporting (block 58) the generated CIM file 24. For example, the spatial server 12 may export the CIM file 24 to the external data systems 28, which may include a DMS, OMS, MDM, or similar external data system that may require synchronization with the GIS system 10. Accordingly, the external systems 28 may then import the file 24 to synchronize with the spatial server 12. The techniques described herein may also be used, for example, by the external systems 28 to produce an equivalent file 24 and thus maintain synchronization across the enterprise.

Technical effects of the disclosed embodiments include systems and methods to enable the communicative coupling and synchronization between GIS systems to a variety of external systems. In certain embodiments, open standard models are used to share information between the communicatively coupled systems. By using open standards, any system support the standards may participate. However, changes to models may result in the entirety of the changed model being transmitted to interested systems. The techniques described herein may derive model changes and transmit only a subset of the changed model, rather than the entirety of the changed model. Changes may be derived based on localized searching of a graph (e.g., a representation of a utility network model), rather than be searching the entire graph for differences. By deriving only the changes (e.g., deriving a Common Information Model (CIM) model of the changes), the present embodiments may improve information synchronization between GIS systems and external systems, and may reduce transmission times and cost by deriving and transmitting the derived differences only.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

Various aspects and embodiments of the present invention are defined by the following numbered clauses:
1. A system, comprising:
   a processor configured to:
      indentify a modification to a utility grid;
      derive a first model of the utility grid and a second model of the utility grid, wherein the second model of the utility grid comprises a modification of the first model of the utility grid;
      compare the first model of the utility grid to the second model of the utility grid; and
      derive a difference between the first model of the utility grid and the second model of the utility grid based at least in part on the comparison.
2. The system of clause 1, wherein the utility grid comprises an electric power grid, gas distribution grid, a water distribution grid, or a combination thereof.
3. The system of any preceding clause, wherein the processor is configured to identify an addition, a deletion, an update, or a combination thereof, of a component of the utility grid as the modification.
4. The system of any preceding clause, wherein the first model of the utility grid comprises a Common Information Model (CIM) model of the utility grid preceding the modification, and wherein the second model of the utility grid comprises a CIM model of the utility grid succeeding the modification.
5. The system of any preceding clause, wherein the processor is configured to generate a Common Information Model (CIM) file based at least in part on the derived difference, and to store the derived difference in the CIM file, wherein the derived difference comprises a portion of the second model of the utility grid.
6. The system of any preceding clause, wherein the processor is configured to store a forward difference data in a section of the CIM file, wherein the forward difference data comprises data relating to an addition of a component to the utility grid.
7. The system of any preceding clause, wherein the processor is configured to store a reverse difference data in a section of the CIM file, wherein the reverse difference data comprises data relating to a deletion or an update of a component of the utility grid.
8. The system of any preceding clause, wherein the processor is configured to:
   derive the first model of the utility grid comprising the utility grid in a pre-existing state, wherein the first model comprises a first Common Information Model (CIM) model;
   derive the second model of the utility grid comprising the utility grid in a modified state, wherein the second model comprises a second CIM model;
   extract each difference between the first model of the utility grid and the second model of the utility grid; and
   generate a CIM file based on each extracted difference, wherein the CIM file comprises only data corresponding to that which is different between the first model of the utility grid and the second model of the utility grid.
9. The system of any preceding clause, wherein the processor is configured to derive a plurality of differences between the first model of the utility grid and the second model of the utility grid.
10. The system of any preceding clause, comprising a Geographic Information System (GIS) including the processor.
11. The system of any preceding clause, wherein the processor is configured to transmit a file including the derived difference to a Distribution Management System (DMS), an Outage Management System (OMS), a Meter Data Management System (MDM), or any combination thereof.
12. A non-transitory computer-readable medium having computer executable code stored thereon, the code comprising instructions to:
   identify one or more modifications to a geographic information system (GIS) model;
   derive a first model of the GIS model and a second model of the GIS model, wherein the second model comprises a modification of the first model;
   compare the first model to the second model; and
   derive a difference between the first model and the second model based at least in part on the comparison.
13. The non-transitory computer-readable medium of any preceding clause, wherein the code comprises instructions to generate a Common Information Model (CIM) file based at least in part on the derived difference, and to store the derived difference in the CIM file, wherein the derived difference comprises a portion of the second model of the GIS model.
14. The non-transitory computer-readable medium of any preceding clause, wherein the code comprises instructions to store a forward difference data in a section of the CIM file, wherein the forward difference data comprises data relating to an addition of a component to a utility grid.
15. The non-transitory computer-readable medium of any preceding clause, wherein the code comprises instructions to store a reverse difference data in a section of the CIM file, wherein the reverse difference data comprises data relating to a deletion of a component from a utility grid.
16. The non-transitory computer-readable medium of any preceding clause, wherein the code comprises instructions to:
   derive the first model based on a utility grid in a pre-existing state, wherein the first model comprises a first Common Information Model (CIM) model;
   derive the second model based on the utility grid in a modified state, wherein the second model comprises a second CIM model;
   extract each difference between the first model and the second model; and
   generate a CIM file based on each extracted difference, wherein the CIM file comprises only data corresponding to differences between the first model and the second model.
17. The non-transitory computer-readable medium of any preceding clause, wherein the code comprises instructions to determine a plurality of differences between the first model and the second model.
18. A system, comprising:
   a Geographic Information System (GIS) comprising a processor configured to:
      generate a representation of an electric power grid in a first state;
      receive an input as an indication to change the representation of the electric power grid to a second state;
      derive a first model of the electric power grid in the first state and a second model of the electric power grid in the second state, wherein the second model of the electric power grid comprises at least one difference from the first model of the electric power grid;
      compare the first model of the electric power grid to the second model of the electric power grid to quantify the at least one difference; and
      derive a Common Information Model (CIM) representation of the at least one difference between the first model of the utility grid and the second model of the utility grid based at least in part on the comparison.
19. The system of any preceding clause, wherein the processor is configured to generate a CIM file based at least in part on the at least one difference, wherein the CIM file is configured to store the representation of the at least one difference.
20. The system of any preceding clause, comprising an external system communicatively coupled to the GIS, wherein the external system comprises a second representation of the electric power grid in the first state, and wherein the processor is configured to transmit the CIM file to the external system to incorporate the at least one difference into the second representation of the electric power grid.

## Claims

1. A system (12), comprising:
a processor configured to:
identify a modification to a utility grid;
derive a first model (30) of the utility grid and a second model (32) (32) of the utility grid, wherein the second model (32) of the utility grid comprises a modification of the first model (30) of the utility grid;
compare the first model (30) of the utility grid to the second model (32) of the utility grid; and
derive a difference between the first model (30) of the utility grid and the second model (32) of the utility grid based at least in part on the comparison.

2. The system of claim 1, wherein the utility grid comprises an electric power grid, gas distribution grid, a water distribution grid, or a combination thereof.

3. The system of claim 1 or claim 2, wherein the processor is configured to identify an addition, a deletion, an update, or a combination thereof, of a component of the utility grid as the modification.

4. The system of claim 1, 2 or 3 wherein the first model (30) of the utility grid comprises a Common Information Model (CIM) model of the utility grid preceding the modification, and wherein the second model (32) of the utility grid comprises a CIM model of the utility grid succeeding the modification.

5. The system of any preceding claim, wherein the processor is configured to generate a Common Information Model (CIM) file (24) based at least in part on the derived difference, and to store the derived difference in the CIM file (24), wherein the derived difference comprises a portion of the second model (32) of the utility grid.

6. The system of claim 5, wherein the processor is configured to:
store a forward difference data in a section of the CIM file (24), wherein the forward difference data comprises data relating to an addition of a component to the utility grid, and/or
store a reverse difference data in a section of the CIM file (24), wherein the reverse difference data comprises data relating to a deletion or an update of a component of the utility grid.

7. The system of any preceding claim, wherein the processor is configured to:
derive the first model (30) of the utility grid comprising the utility grid in a pre-existing state, wherein the first model (30) comprises a first Common Information Model (CIM) model;
derive the second model (32) of the utility grid comprising the utility grid in a modified state, wherein the second model (32) comprises a second CIM model;
extract each difference between the first model (30) of the utility grid and the second model (32) of the utility grid; and
generate a CIM file (24) based on each extracted difference, wherein the CIM file (24) comprises only data corresponding to that which is different between the first model (30) of the utility grid and the second model (32) of the utility grid.

8. The system of any preceding claim, comprising a Geographic Information System (GIS) (10) including the processor.

9. The system of any preceding claim, wherein the processor is configured to transmit a file including the derived difference to a Distribution Management System (DMS), an Outage Management System (OMS), a Meter Data Management System (MDM), or any combination thereof.

10. A non-transitory computer-readable medium having computer executable code stored thereon, the code comprising instructions to:
identify (50) one or more modifications to a geographic information system (GIS) model;
derive (52) a first model of the GIS model and a second model of the GIS model, wherein the second model comprises a modification of the first model;
compare (54) the first model to the second model; and
derive a difference between the first model and the second model based at least in part on the comparison.

11. The non-transitory computer-readable medium of claim 10, wherein the code comprises instructions to generate (56) a Common Information Model (CIM) file based at least in part on the derived difference, and to store the derived difference in the CIM file, wherein the derived difference comprises a portion of the second model of the GIS model.

12. The non-transitory computer-readable medium of claim 11, wherein the code comprises instructions to:
store a forward difference data in a section of the CIM file, wherein the forward difference data comprises data relating to an addition of a component to a utility grid, and/or
store a reverse difference data in a section of the CIM file, wherein the reverse difference data comprises data relating to a deletion of a component from a utility grid.

13. The non-transitory computer-readable medium of claim 10, 11 or 12, wherein the code comprises instructions to:
derive (52) the first model based on a utility grid in a pre-existing state, wherein the first model comprises a first Common Information Model (CIM) model;
derive (52) the second model based on the utility grid in a modified state, wherein the second model comprises a second CIM model;
extract each difference between the first model and the second model; and
generate (56) a CIM file based on each extracted difference, wherein the CIM file comprises only data corresponding to differences between the first model and the second model.

14. The non-transitory computer-readable medium of any one of claims 10 to 13, wherein the code comprises instructions to determine a plurality of differences between the first model and the second model.

15. A system, comprising:
a Geographic Information System (GIS) (10) comprising a processor configured to:
generate a representation of an electric power grid in a first state;
receive (50) an input as an indication to change the representation of the electric power grid to a second state;
derive (52) a first model of the electric power grid in the first state and a second model of the electric power grid in the second state, wherein the second model of the electric power grid comprises at least one difference from the first model of the electric power grid;
compare (54) the first model of the electric power grid to the second model of the electric power grid to quantify the at least one difference; and
derive (56) a Common Information Model (CIM) representation of the at least one difference between the first model of the utility grid and the second model of the utility grid based at least in part on the comparison.

16. The system of claim 15, comprising an external system (28) communicatively coupled to the GIS (10), wherein the external system (28) comprises a second representation of the electric power grid in the first state, and wherein the processor is configured to:
transmit (58) the CIM file to the external system to incorporate the at least one difference into the second representation of the electric power grid.
